Europäisches Patentamt

European Patent Office

Office européen des brevets

(19)

(11) Veröffentlichungsnummer : **0 018 598**
**B1**

(12) **EUROPÄISCHE PATENTSCHRIFT**

(45) Veröffentlichungstag der Patentschrift :
22.06.83

(51) Int. Cl.³ : **H 02 H 9/02**, H 03 K 17/08,
**H 02 M 1/18**

(21) Anmeldenummer : 80102214.6

(22) Anmeldetag : 24.04.80

(54) Schaltungsanordnung zur Begrenzung des Schaltstroms in einem aus einem Durchflussstromwandler, einem Schalthalbleiter, einer Schutzinduktivität und einer Überstromabschaltung in Serienschaltung gebildeten Stromkreis.

(30) Priorität : 25.04.79 DE 2916775

(43) Veröffentlichungstag der Anmeldung :
12.11.80 Patentblatt 80/23

(45) Bekanntmachung des Hinweises auf die Patenterteilung : 22.06.83 Patentblatt 83/25

(84) Benannte Vertragsstaaten :
AT CH DE FR GB LI NL

(56) Entgegenhaltungen :
DE A 2 651 492
DE A 2 716 367
US A 4 025 863
US A 4 122 385
ELECTRONIK, Band 28, Nr. 6, März 1979, München J. RYMUS « Integrierte Schaltungen in getakteten Netzteilen » Seiten 64 bis 68

(73) Patentinhaber : **Nixdorf Computer Aktiengesellschaft**
**Fürstenallee 7**
**D-4790 Paderborn (DE)**

(72) Erfinder : **Pollmeier, Werner**
**Mozartweg 8**
**D-4831 Verl 1 (DE)**

(74) Vertreter : **Patentanwälte Schaumburg,**
**Schulz-Dörlam & Thoenes**
**Mauerkircherstrasse 31**
**D-8000 München 80 (DE)**

**Schaltungsanordnung zur Begrenzung des Schaltstroms in einem aus einem Durchflußstromwandler, einem Schalthalbleiter, einer Schutzinduktivität und einer Überstromabschaltung in Serienschaltung gebildeten Stromkreis**

Die Erfindung betrifft eine Schaltungsanordnung zur Begrenzung des Schaltstroms in einem aus einem Durchflußstromwandler, einem Schalthalbleiter, einer Schutzinduktivität und einer Überstromabschaltung in Serienschaltung gebildeten Stromkreis, bei dem die Zeitkonstante der Überstromabschaltung durch die Schutzinduktivität so weit vergrößert ist, daß die Abschaltung bei einem Teilwert des vollen Überstromes erfolgt, und die Überstromabschaltung eine Ansprechzeit aufweist.

Aus der DE-A 26 51 492 ist eine Schaltungsanordnung ähnlicher Art bekannt, die nicht einen Durchflußstromwandler, sondern eine verlustbehaftete Induktivität enthält und bei der keine besondere Überstromabschaltung vorgesehen ist. Durch die Schutzinduktivität wird eine Strombegrenzung beim Einschalten des Schalthalbleiters erreicht und dadurch seine Einschaltleistung herabgesetzt. Prinzipiell könnte diese Art der Schaltleistungsbegrenzung auch dann angewendet werden, wenn ein Überstrom durch Sättigung der verlustbehafteten Induktivität entsteht, jedoch sind entsprechende Lösungswege insbesondere in Verbindung mit der Überstromabschaltung bei einem Durchflußstromwandler nicht aufgezeigt.

Die magnetische Sättigung des Kernmaterials einer Induktivität kann unterschiedliche Ursachen haben. Ein erster Grund für die magnetische Sättigung kann in einer zu hohen Betriebsspannung bestehen, an die die Induktivität und das mit ihr in Reihe geschaltete zu schützende Bauelement angeschaltet sind. Ferner kann eine magnetische Sättigung dadurch erreicht werden, daß ein mit der Induktivität in Reihe geschalteter Schalter, also beispielsweise der bereits genannte Schalthalbleiter, zu lange eingeschaltet bleibt, so daß der Magnetisierungsstrom der Induktivität den Sättigungswert überschreitet. Dieser Fehler kann beispielsweise in Stromwandlerschaltungen auftreten, bei denen ein Schalthalbleiter mit der Primärwicklung eines Wandlerübertragers in Reihe geschaltet ist. Bei Eintakt-Durchflußstromwandlern kann ferner eine unzureichende Entmagnetisierung der Induktivität des Wandlerübertragers vor dem jeweils erneuten Einschalten des Schalthalbleiters auftreten, wodurch gleichfalls eine magnetische Sättigung des Wandlerübertragers hervorgerufen wird. Entsprechend kann dieser Zustand bei einem Gegentakt-Durchflußstromwandler dann eintreten, wenn der Wandlerübertrager vor dem jeweils erneuten Einschalten des Schalthalbleiters unzureichend gegenmagnetisiert wurde.

Die vorstehend beschriebenen Fälle treten durch Störungen der speisenden Spannungsquelle oder auch der Steuerstromkreise innerhalb der beschriebenen Stromwandlerschaltungen auf. Bei einem Gegentakt-Durchflußstromwandler ist grundsätzlich beim erstmaligen Einschalten mit einer Sättigung zu rechnen, wenn nicht für den Einschaltefall eine zusätzliche Reduzierung der Bestromungszeit vorgesehen wird. Bei Schaltungen dieser Art kann auch eine Unsymmetrie der Schaltzeiten der verwendeten Schalthalbleiter und eine damit verbundene Gleichstromvorbelastung des Wandlerübertragers eine magnetische Sättigung hervorrufen.

Durch die magnetische Sättigung des Kernmaterials einer Induktivität tritt eine sehr starke Verringerung des Induktivitätwertes ein, die mit einem über der Zeit sehr steilen Stromanstieg verbunden ist. Es ist nun möglich, besondere Schutzschaltungen zur Überstromabschaltung vorzusehen, die bei Erreichen des der magnetischen Sättigung entsprechenden Stromwertes den Stromkreis, in dem die sättigbare Induktivität liegt, auftrennen. Derartige Überstromabschaltungen erfolgen jedoch mit einer unvermeidlichen Verzögerung, so daß das zu schützende Bauelement während der Verzögerungszeit noch einer relativ hohen Stromüberhöhung ausgesetzt ist. Besonders nachteilig macht sich eine derartige Verzögerung im Falle der Reihenschaltung von Induktivitäten mit Schalthalbleitern bemerkbar, denn diese haben aufgrund ihrer ziemlich langen Speicherzeit in der Größenordnung von ca. 2 bis 3 Mikrosekunden eine entsprechend lange Schaltverzögerung, innerhalb der sie durch die beschriebene Stromüberhöhung zerstört werden können, auch wenn eine besondere Stromüberwachungsschaltung ihre Abschaltung bei Erreichen des Sättigungszustandes der mit ihnen in Reihe geschalteten Induktivität veranlaßt.

Die Aufgabe der Erfindung besteht darin, bei einem Durchflußstromwandler einen besseren Schutz für den mit der sättigbaren Induktivität in Reihe geschalteten Schalthalbleiter anzugeben, durch den auch während einer Schaltverzögerung der Überstromabschaltung eine zu hohe Stromüberhöhung zuverlässig vermieden wird.

Eine Schaltungsanordnung eingangs genannter Art ist zur Lösung dieser Aufgabe erfindungsgemäß derart ausgebildet, daß zum Schutz des im Primärstromkreis des Durchflußstromwandlers angeordneten Schalthalbleiters gegen durch magnetische Sättigung des Wandlerübertragers verursachten Überstrom die Schutzinduktivität unter Einbeziehung der Sättigungsinduktivität des Wandlerübertragers so bemessen ist, daß während der durch Übergang des Wandlerübertragers in die magnetische Sättigung vorhandenen Ansprechzeit der Überstromabschaltung höchstens der maximale für den Schalthalbleiter zulässige Stromwert erreicht wird.

Durch die Erfindung wird erreicht, daß die aus der Sättigungsinduktivität und der Schutzinduktivität gebildete Gesamtinduktivität einen Magnetisierungsstromverlauf über der Zeit hat, der nicht mehr den durch die magnetische Sättigung bedingten charakteristischen Knick und die damit verbundene außerordentlich hohe Steilheit im Sättigungsgebiet aufweist. Wenn als Schutzinduktivität eine Anordnung verwendet wird, deren Magnetisierungsstrom über der Zeit mindestens so lange linear verläuft, wie dies bei der Induktivität des Wandlerübertragers der Fall ist, und wenn dieser Magnetisierungsstrom zusätzlich während der Ansprechzeit einer Überstromabschaltung den für das Bauelement zulässigen maximalen Stromwert nicht überschreitet, so ist damit die Charakteristik der Schutzinduktivität so festgelegt, daß bei ihr eine magnetische Sättigung innerhalb des hier betrachteten Zeitraumes nicht auftreten kann. Dies bedeutet, daß die Schutzinduktivität etwa die Eigenschaften einer Speicherdrossel haben kann, deren Hysteresekennlinie durch einen Luftspalt im Kernmaterial geschert ist und die deshalb über einen zeitlich etwa konstanten Stromanstieg verfügt.

Wird die Reihenschaltung der beiden Induktivitäten beispielsweise durch einen Schalthalbleiter laufend an eine Spannungsquelle angeschaltet und tritt einer der vorstehend beschriebenen Störungsfälle ein, so kann sich im Falle einer Sättigung der Induktivität des Wandlerübertragers keinesfalls eine Sättigung der Schutzinduktivität einstellen, da deren Charakteristik in angegebener Weise festgelegt ist. Die Schutzinduktivität wirkt also wie ein mit der Induktivität des Wandlerübertragers in Reihe geschalteter Strombegrenzungswiderstand, so daß der die Reihenschaltung insgesamt durchfließende Strom innerhalb der genannten Ansprechzeit einer Überstromabschaltung den für den Schalthalbleiter zulässigen maximalen Stromwert nicht überschreiten kann.

Die Schaltungsanordnung kann derart weiter ausgebildet sein, daß der Schutzinduktivität eine Diode parallelgeschaltet ist, die so gepolt ist, daß sie beim Auftrennen der Reihenschaltung auftretende Überspannungen kurzschließt. Auch kann diese Diode mit einer Zenerdiode und/oder mit einem ohmschen Widerstand in Reihe geschaltet sein. Durch diese zusätzlichen Elemente wird eine beschleunigte Entladung der Schutzinduktivität über die genannte Diode erreicht, da sie die Entladungszeitkonstante verkürzen.

Die Erfindung wird im folgenden anhand der Figuren beschrieben. Es zeigen :

Figur 1 ein Ausführungsbeispiel der Erfindung,

Figur 2 die durch die Erfindung erzielbare Magnetisierungsstromcharakteristik einer Reihenschaltung gemäß Fig. 1, die eine sättigbare Induktivität, die ihr vorgeschaltete Schutzinduktivität sowie eine ohmsche Last enthält und

Figur 3 ein Anwendungsbeispiel der Erfindung bei einem Eintakt-Durchflußstromwandler in der schaltungstechnischen Ausführung.

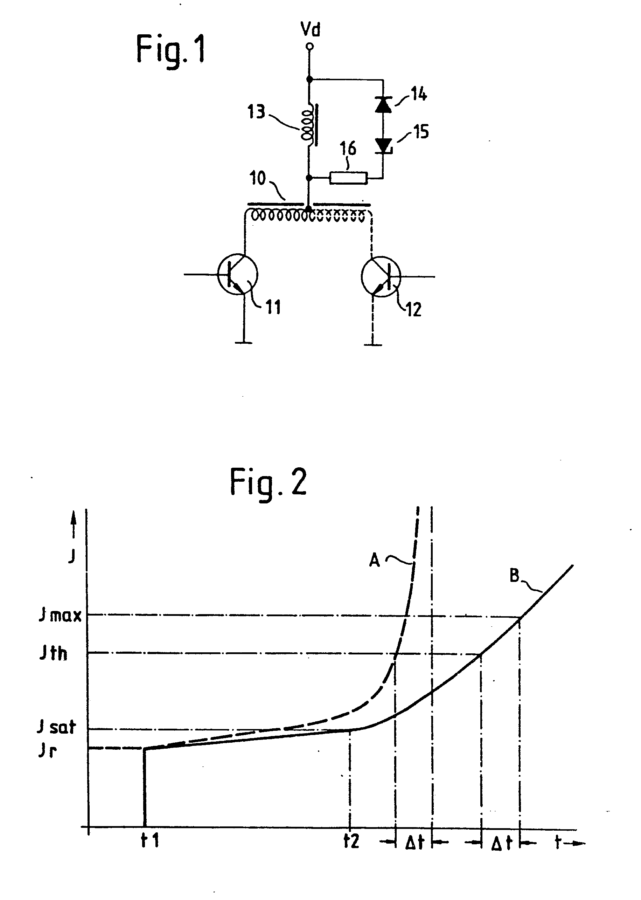

In Figur 1 ist schematisch eine Induktivität 10 mit Eisenkern dargestellt, die mit einem Schalthalbleiter 11 und einer weiteren Induktivität 13 in Reihe geschaltet ist. Diese Reihenschaltung ist an eine Betriebsspannung + Vd angeschaltet und kann beispielsweise der Primärstromkreis eines Eintakt-Durchflußstromwandlers sein. Ferner ist gestrichelt ein weiterer Teil der Induktivität 10 dargestellt, der über eine gestrichelt gezeigte Verbindung mit einem weiteren Schalthalbleiter 12 verbunden ist, so daß durch diese Ergänzung ein Gegentakt-Durchflußstromwandler dargestellt ist, wobei in diesem Falle dann die zweite Induktivität 13 an einen Mittelabgriff der Induktivität 10 angeschaltet ist. Die Arbeitsweise eines Durchflußstromwandlers gehört zum Stand der Technik und muß deshalb hier nicht weiter erläutert werden.

Tritt einer der oben beschriebenen Störungsfälle in dem beschriebenen, mit der Betriebsspannung Vd verbundenen Stromkreis ein, so kann die Induktivität 10 des Wandlerübertragers, dessen Sekundärwicklung in Figur 1 nicht dargestellt ist, in die magnetische Sättigung geführt werden, wodurch der Schalthalbleiter 11 sowie ggf. der Schalthalbleiter 12 zerstört werden kann. Dies ist darauf zurückzuführen, daß trotz einer ggf. vorhandenen, in Figur 1 nicht dargestellten Überstromabschaltung eine Verzögerung zwischen der Ansteuerung des jeweiligen Schalthalbleiters 11 bzw. 12 und dem tatsächlichen Auftrennen des in Figur 1 dargestellten Stromkreises liegt, innerhalb der der Magnetisierungsstrom der Induktivität 10 so stark ansteigen könnte, daß er den für den jeweiligen Schalthalbleiter zulässigen maximalen Stromwert überschreitet. Diese Erscheinung wird jedoch durch die zweite Induktivität 13 verhindert, die in bereits beschriebener Weise dimensioniert ist und einen derart starken Magnetisierungsstromanstieg in dem in Figur 1 gezeigten Stromkreis während der beschriebenen Ansprechzeit unmöglich macht.

Der zweiten Induktivität 13 ist eine Diode 14 parallelgeschaltet, die bei Auftrennung des Stromkreises eine Entladung der zweiten Induktivität 13 bewirkt. Zusätzlich sind eine Zenerdiode 15 und ein ohmscher Widerstand 16 dargestellt, die jeweils für sich oder auch gemeinsam mit der Diode 14 in Reihe geschaltet sein können und die Entladung der zweiten Induktivität 13 durch den bereits beschriebenen Effekt einer Verkürzung der Entladezeitkonstante beschleunigen.

Figur 2 zeigt die Magnetisierungsstromcharakteristik der in Figur 1 dargestellten Reihenschaltung, wobei berücksichtigt ist, daß diese Reihenschaltung noch einen ohmschen Lastanteil enthalten kann. Es ist der Magnetisierungsstrom J über der Zeit t dargestellt, beginnend mit einer Einschaltung des Stromkreises zum Zeitpunkt t1. Wird zu diesem Zeitpunkt ein bereits eingeschwungener Zustand der Reihenschaltung vorausgesetzt, so ergibt sich zunächst ein Stromanstieg zur Zeit t1 auf einen Stromwert Jr, der durch den ohmschen Lastanteil bedingt ist. Dann steigt der Magnetisierungsstrom bis zum Zeitpunkt t2 etwa linear an, wobei die Steigung dieses Kennlinienteils durch die Gesamtinduktivität der beiden Induktivitäten 10 und 13 (Figur 1) bestimmt ist. Zum Zeitpunkt t2 wird der Sättigungsstromwert Jsat erreicht, bei dessen Überschreiten der Magnetisierungsstrom durch nahezu völliges Verschwinden des Wertes der Induktivität 10 (Figur 1) sehr steil ansteigen würde, wenn nicht die Induktivität 13 in dem in Figur 1 gezeigten Stromkreis vorgesehen wäre. Dieser sehr steile Magnetisierungsstromanstieg ist in Figur 2 durch die gestrichelt Linie A dargestellt.

Die Überstromabschaltung bzw. die Abschaltung eines Schalthalbleiters 11 und/oder 12 (Figur 1) mögen nun mit einer Verzögerung Δt erfolgen, die in Figur 2 gezeigt ist. Innerhalb dieser Verzögerungszeit würde eine Überhöhung des Magnetisierungsstroms gemäß dem Kennlinienteil A auftreten, die den maximalen zulässigen Stromwert Jmax für das zu schützende Bauelement bei weitem übersteigen würde, so daß es zerstört werden könnte, nachdem die Stromschwelle Jth für das Ansprechen einer ggf. vorhandenen Überstromabschaltung überschritten ist. Durch die im Stromkreis zusätzlich vorhandene zweite Induktivität 13 wird der Anstieg des Magnetisierungsstroms nun soweit verringert, daß sich der in Figur 2 gezeigte Kennlinienabschnitt B ergibt. Dies bedeutet, daß in der in Figur 1 gezeigten Reihenschaltung noch im wesentlichen der Induktivitätswert der zweiten Induktivität 13 verbleibt, wenn von einem etwa noch vorhandenen Restwert der ersten Induktivität 10 abgesehen wird. Durch die geringere Steigung des Kennlinienabschnittes B wird erreicht, daß der Magnetisierungsstrom innerhalb der Zeit Δt höchstens vom Stromwert Jth auf den maximalen zulässigen Stromwert Jmax ansteigt. Dadurch ist gewährleistet, daß das zu schützende Bauelement über diesen Stromwert hinausgehend nicht belastet wird, so daß es vor einer Auftrennung des in Figur 1 gezeigten Stromkreises nicht zerstört werden kann.

Aus der vorstehenden Beschreibung ergibt sich, daß die beschriebene Schaltungsanordnung allgemein der folgenden Bedingung genügen muß :

$$\Delta t \cdot Vd/Jmax - Jth \leq L13 + L10 \; sat$$

Hierbei sind L13 und L10 sat die Induktivitätswerte der zweiten Induktivität 13 bzw. der ersten Induktivität 10 im gesättigten Zustand und Vd die Betriebsspannung.

Bei einem praktischen Anwendungsfall in einer Durchflußwandlerschaltung kann die Zeit zwischen dem Einschalten des in Figur 1 gezeigten Stromkreises und dem Erreichen der Stromschwelle Jth bei etwa 20 Mikrosekunden liegen, während die Zeit Δt etwa 3 Mikrosekunden beträgt.

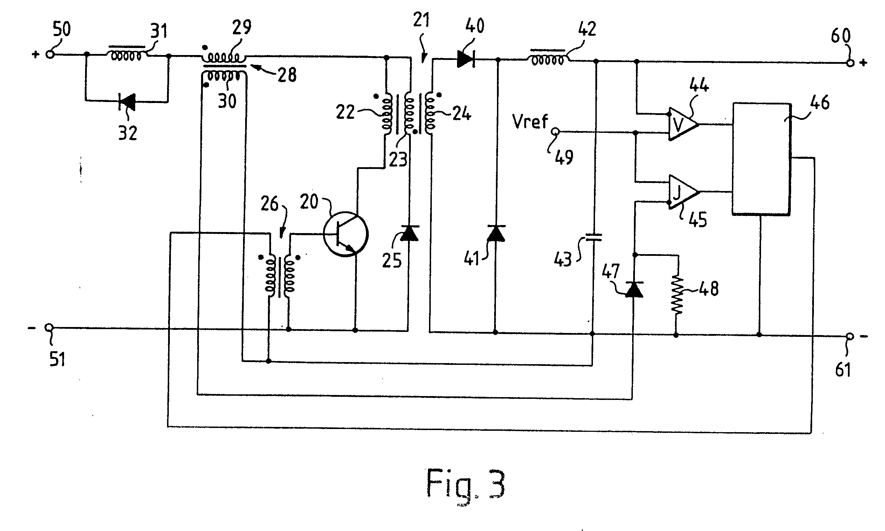

In Figur 3 ist ein Eintakt-Durchflußstromwandler in seiner schaltungstechnischen Ausführung in Verbindung mit einer Schaltungsanordnung nach der Erfindung dargestellt. Bei diesem Wandler erfolgt der über seinen Übertrager 21 zu übertragenden Energiefluß in der einschaltphase des Schalttransistors 20. Mit diesem Schalttransistor 20 ist die Primärwicklung 22 des Übertragers 21 in Reihe geschaltet, und diese Reihenschaltung ist mit den Eingangsanschlüssen 50 und 51 verbunden, an denen eine Speisespannung liegt, die mit dem Eintakt-Durchflußstromwandler in eine von ihr verschiedene Ausgangsspannung umzusetzen ist, welche an den Ausgangsanschlüssen 60 und 61 abgenommen werden kann.

Der Übertrager 21 hat eine Sekundärwicklung 24, deren Enden mit zwei Gleichrichterdioden 40 und 41 verbunden sind. Die an dem Verbindungspunkt der beiden Gleichrichterdioden 40 und 41 auftretende pulsierende Gleichspannung wird mit einer Filterschaltung geglättet, die aus einer Drosselspule 42 und einem Kondensator 43 besteht. Die hinter der Filterschaltung auftretende geglättete Gleichspannung liegt an dem Ausgangsanschluß 60 und ferner an einem invertierenden Eingang eines Spannungsvergleichers 44, der die geglättete Gleichspannung mit einer Referenzspannung Vref vergleicht, die ihm über einen Anschluß 49 zugeführt wird. Wenn eine Abweichung der geglätteten Gleichspannung von der Referenzspannung Vref auftritt, so gibt der Spannungsvergleicher 44 ein dieser Abweichung entsprechendes Ausgangssignal an eine Steuereinheit 46. Diese Steuereinheit 46 enthält einen Pulslängenmodulator, dessen Ausgangssignale konstanter Frequenz und entsprechend der Abweichung variabler Impulslänge über einen Übertrager 26 der Steuerelektrode des Schalttransistors 20 zugeführt werden.

Die Einschaltdauer und damit die Impulslänge der Ausgangssignale der Steuereinheit 46 liegt zwischen Null und 50 % der Periodendauer. Dies bedeutet, daß im Leerlauf die Steuereinheit 46 den Schalttransistor 20 nur sehr kurzzeitig leitend steuert. Bei Belastung des Stromwandlers beträgt die Einschaltdauer des Schalttransistors 20 höchstens 50 % der Periodendauer, denn in der Sperrphase des Stromwandlers muß der Übertrager 21 über seine Wicklung 23 und die mit ihr in Reihe geschaltete Diode 25 entmagnetisiert werden.

Der Primärwicklung 22 des Übertragers 21 ist ein weiterer Übertrager 28 mit einer Primärwicklung 29 und einer Sekundärwicklung 30 vorgeschaltet. Mit diesem Übertrager 28 wird der jeweilige Augenblickswert des durch den Schalttransistor 20 fließenden Stroms festgestellt und unter Veränderung entsprechend dem Übersetzungsverhältnis des Übertragers 28 über eine Diode 47 einem Meßwiderstand 48 und einem Stromvergleicher 45 an dessen invertierendem Eingang zugeführt. Der Stromvergleicher 45 erhält an seinem zweiten Eingang ferner die Referenzspannung Vref.

Wenn der an dem Meßwiderstand 48 auftretende, dem pulsierenden Schaltstrom des Schalttransistors 20 proportionale Spannungswert die Referenzspannung Vref überschreitet, so gibt der Stromvergleicher 45 ein Ausgangssignal an die Steuereinheit 46 ab, wodurch der Schalttransistor 20 mit einem Ausgangssignal der Steuereinheit 46 über den Übertrager 26 für längere Zeit abgeschaltet werden kann. Dieser Vorgang tritt beispielsweise bei einer magnetischen Sättigung der Induktivität des Übertragers 21 auf, wie sie weiter oben bereits erläutert wurde. In diesem Fall fällt der Induktivitätswert auf der Primärseite des Übertragers 21 auf einen geringen Wert ab, und es erfolgt dadurch ein sehr schneller Stromanstieg noch innerhalb der Speicherzeit des Schalttransistors 20. Auch wenn durch das Ausgangssignal der Steuereinheit 46 der Steuerstrom für den Schalttransistor 20 abgeschaltet wird, so bleibt dieser doch noch für seine Speicherzeit, die etwa in der Größenordnung von etwa $3 \mu s$ liegen kann, leitend und kann durch die beschriebene Stromüberhöhung im Sättigungsfall der Induktivität des Übertragers 21 zerstört werden.

Um den Schalttransistor 20 vor dieser Stromüberhöhung während seiner Abschaltezeit zu schützen, ist ihm zusätzlich zu dem Übertrager 28 eine Parallelschaltung aus einer Induktivität 31 und einer Diode 32 vorgeschaltet. Die Funktion dieser Anordnung wurde bereits in Verbindung mit Figuren 1 und 2 erläutert. Die Induktivität 31 erzeugt während der Abschaltezeit des Schalttransistors 20 eine Strombegrenzung.

Unter Berücksichtigung der oben angegebenen allgemeinen Bedingung, der die Schutzschaltung genügen muß, ergibt sich für die Induktivität 31 bei einer Betriebsspannung von 400 V, einer Ausschaltezeit des Schalttransistors 20 von $3 \mu s$ und einer Stromdifferenz Jmx — Jth von 2,4 A ein Induktivitätswert von 0,48 mH. In diesem Zusammenhang ist zu berücksichtigen, daß die Schutzfunktion der Induktivität 31 auch für den auf einen Störungsfall folgenden Einschaltezyklus des Schalttransistors 20 sichergestellt sein muß. Die Stromwandlerschaltung muß also im Falle der vorstehend beschriebenen Abschaltung durch das Ausgangssignal der Steuereinheit 46 solange abgeschaltet bleiben, bis der Strom durch die Induktivität 31 während des Schutzvorgangs unter den Schwellenwert Jth des Stromvergleichers 45 abgefallen ist. Dies bedeutet, daß die Zeit, für die die Steuereinheit 46 den Schalttransistor 20 abgeschaltet hält, der Entmagnetisierungszeit der Induktivität 31 angepaßt sein muß. Diese Entmagnetisierungszeit beträgt unter Berücksichtigung der vorstehend angegebenen Zahlenwerte bei einem minimalen Spannungsabfall an der Diode 32 von 0,5 V mindestens 2,4 ms.

Die erforderliche Ausschaltezeit kann dadurch reduziert werden, daß, wie in Figur 1 angegeben, mit der Diode 32 ein Widerstand und/oder eine Zenerdiode in Reihe geschaltet wird.

Da die Induktivität 31 eine relativ lange Entmagnetisierungszeit hat, muß ihr Kern nicht unbedingt aus Hochfrequenzmaterial bestehen. Es genügt, wenn als Kernwerkstoff normales Transformatorenblech verwendet wird, so daß gegenüber Ferritmaterial eine relativ große Preis- und Volumenreduzierung möglich ist.

## Ansprüche

1. Schaltungsanordnung zur Begrenzung des Schaltstromes in einem aus einem Durchflußstromwandler, einem Schalthalbleiter (11, 12 ; 20), einer Schutzinduktivität (13 ; 31) und einer Überstromabschaltung in Serienschaltung gebildeten Stromkreis, bei dem die Zeitkonstante der Überstromabschaltung durch die Schutzinduktivität (13 ; 31) so weit vergrößert ist, daß die Abschaltung bei einem Teilwert des vollen Überstromes erfolgt, und die Überstromabschaltung eine Ansprechzeit aufweist, dadurch gekennzeichnet, daß zum Schutz des im Primärstromkreis des Durchflußstromwandlers angeordneten Schalthalbleiters (11, 12 ; 20) gegen durch magnetische Sättigung des Wandlerübertragers (10 ; 21) verursachten Überstrom die Schutzinduktivität (13 ; 31) unter Einbeziehung der Sättigungsinduktivität des Wandlerübertragers (10 ; 21) so bemessen ist, daß während der durch Übergang des Wandlerübertragers (10 ; 21) in die magnetische Sättigung vorhandenen Ansprechzeit der Überstromabschaltung höchstens der maximale für den Schalthalbleiter (11, 12 ; 20) zulässige Stromwert erreicht wird.

2. Schaltungsanordnung nach Anspruch 1, dadurch gekennzeichnet, daß der Schutzinduktivität (13 ; 31) eine Diode (14 ; 32) parallelgeschaltet ist, die so gepolt ist, daß sie beim Auftrennen der Reihenschaltung auftretende Überspannungen kurzschließt.

3. Schaltungsanordnung nach Anspruch 2, dadurch gekennzeichnet, daß mit der Diode (14) ein ohmscher Widerstand (16) in Reihe geschaltet ist.

4. Schaltungsanordnung nach Anspruch 2 oder 3, dadurch gekennzeichnet, daß mit der Diode (14) eine Zenerdiode (15) in Reihe geschaltet ist.

## Claims

1. Circuit arrangement for limiting the switching current in a circuit formed by a through-flow current converter, a semiconductive switch (11, 12 ; 20), a protective inductor (13 ; 31) and an overload current cut-out in series connection, in which circuit the time constant of the overload current cut-out is increased to such an extent by the protective inductor (13 ; 31) that cut-out occurs at a partial value of the full overcurrent, and the overload current cut-out has a response time, characterised in that for protection of the semiconductive switch (11, 12 ; 20) arranged in the primary circuit of the through-flow current converter against excess current caused by magnetic saturation of the converter's transformer (10 ; 21) the protective inductor (13 ; 31) including the saturation inductance of the converter transformer (10 ; 21) is so adjusted that during the overload cut-out's response time that is available because of the transition of the converter's transformer (10 ; 21) into magnetic saturation at most the maximum permissible current value for the switching semi-conductor (11, 12 ; 20) is attained.

2. Circuit arrangement according to claim 1 characterised in that a diode (14 ; 32) is connected in parallel to the protective inductor (13 ; 31), the diode's polarity being such that it short-circuits excess voltages occurring upon interruption of the series connection.

3. Circuit arrangement according to claim 2, characterised in that an ohmic resistor (16) is connected in series with the diode (14).

4. Circuit arrangement according to claim 2 or 3, characterised in that a Zener diode (15) is connected in series with the diode (14).

**Revendications**

1. Montage pour limiter le courant de commutation dans un circuit constitué par un transformateur de passage, un transistor de commutation (11, 12 ; 20), une inductance protectrice (13 ; 31) et un déclencheur à surintensité connectés en série et dans lequel la constante de temps du déclencheur à surintensité est suffisamment accrue par l'inductance protectrice (13 ; 31) pour que la coupure se produise pour une valeur partielle de la surintensité totale, et le déclencheur à surintensité présente un temps de réponse, caractérisé en ce que pour protéger le transistor de commutation (11, 12 ; 20) monté dans le circuit primaire du convertisseur de courant direct contre des surintensités provoquées par saturation magnétique du transformateur de convertisseur (10 ; 21) l'inductance protectrice (13 ; 31), compte tenu de l'inductance de saturation du transformateur de convertisseur (10 ; 21), est dimensionnée de telle façon que durant le temps de réponse du déclencheur à surintensité, déterminé par le passage du transformateur de convertisseur (10 ; 21) à l'état de saturation magnétique, soit atteinte tout au plus la valeur de courant maximale admissible pour le transistor de commutation (11, 12 ; 20).

2. Montage selon la revendication 1, caractérisé en ce qu'en parallèle avec l'inductance protectrice (13 ; 31) est montée une diode (14 ; 32) qui est polarisée de façon à court-circuiter des surtensions se produisant lors de la coupure du montage en série.

3. Montage selon la revendication 2, caractérisé en ce qu'une résistance ohmique (16) est montée en série avec la diode (14).

4. Montage selon la revendication 2 ou 3, caractérisé en ce qu'une diode Zener (15) est montée en série avec la diode (14).

Fig. 1

Fig. 2

Fig. 3

0 018 598